# EUROPEAN PATENT APPLICATION

(11) **EP 1 577 936 A1**
(43) Date of publication of application: **21.09.2005**
(21) Application number: 03786283.6
(22) Date of filing: 24.12.2003
(51) Int. Cl.: H01L 21/60, H01L 21/288, H01L 21/3205, H01L 29/84, C23C 18/16

(54) **SEMICONDUCTOR SENSOR AND PLATING METHOD FOR SEMICONDUCTOR DEVICE**

(30) Priority: 24.12.2002 JP 2002371960
(71) Applicant: DENSO CORPORATION, Aichi-ken, 448-8661 (JP)
(72) Inventor: TANAKA, Hiroaki, C/O INTELLECTUAL PROPERTY CENTER, Kariya-shi, Aichi 448-8661 (JP); TOYODA, Inao, C/O INTELLECTUAL PROPERTY CENTER, Kariya-shi, Aichi 448-8661 (JP); WATANABE, Yoshifumi, C/O NTELLECTUAL PROP. CENTER, Kariya-shi, Aichi 448-8661 (JP); KONDO, Ichiharu, C/O NTELLECTUAL PROPERTY CENTER, Kariya-shi, Aichi 448-8661 (JP); SHINYAMA, Keiji, C/O NTELLECTUAL PROPERTY CENTER, Kariya-shi, Aichi 448-8661 (JP); ABE, Yositugu, C/O NTELLECTUAL PROPERTY CENTER, Kariya-shi, Aichi 448-8661 (JP)
(74) Representative: Winter, Brandl,&Fürniss, Hübner Röss, Kaiser, Polte Partnerschaft Patent- und Rechtsanwaltskanzlei
(86) International application number: PCT/JP2003/016625
(87) International publication number: WO 2004/059722

(57) **Abstract**

A method of plating a semiconductor wafer while maintaining a uniform thickness of the plated film, preventing the precipitation on the back surface of the wafer and preventing the contamination in the subsequent steps. In directly forming connection terminals on the aluminum electrodes on the semiconductor wafer, the non-electrolytic plating is effected in a state where the back surface of the wafer is covered with an insulator. The insulator is preferably a glass substrate which is a part constituting the product. A semiconductor type sensor exhibits improved corrosion resistance against a corrosive medium. The semiconductor type sensor has, in a semiconductor substrate, a structural portion for detecting the physical quantity or the chemical component of a corrosive medium and an electric quantity conversion element, and has pads which are the output terminals for sending the detected electric signals to an external unit, wherein the pads are protected by a precious metal.

## Description

### Technical Field

The present invention relates to a semiconductor sensor and to a method of plating semiconductor devices during the production thereof.

### Background Art

A semiconductor sensor for detecting physical quantities such as a pressure and a flow rate of a medium to be measured or for detecting chemical components that constitute the medium to be measured, has heretofore been used as a physical quantity sensor or a chemical sensor. A conventional semiconductor type physical quantity sensor uses, for example, pads composed chiefly of aluminum as external terminals for sending the detected electric signals to an external unit. To satisfy the demand for highly accurate control of modern machines and equipment, however, it has been urged to measure physical quantities in a variety of objects, and the corrosion of aluminum due to the medium being measured affects the life of the products.

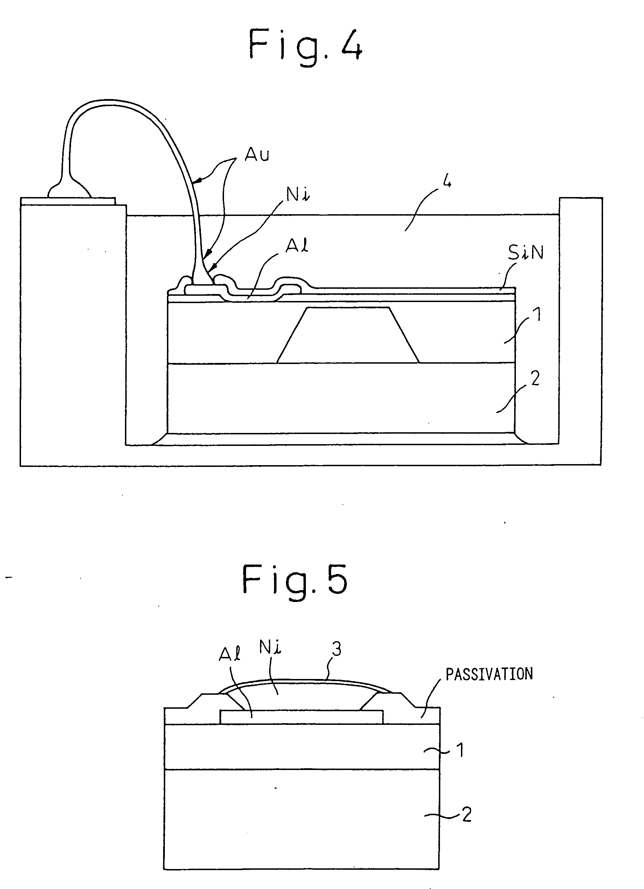

Under such circumstances, a countermeasure such as a gel, shown in Fig. 4, that has heretofore been used, is not enough to prevent the corrosion of aluminum and cannot necessarily satisfy the life of products required in, for example, automobiles.

As for the pads comprising chiefly aluminum, Japanese Patent No. 3198779 teaches a pressure sensor structure, for detecting the pressure of a strongly corrosive, pressurised medium, in which a pressure sensor element is connected to terminal pins by bonding wires and the sensor chip and the wire terminal pins are immersed in an oil and are sealed with a metal diaphragm having resistance against corrosion. However, this structure requires such members as a metal diaphragm, oil and an O-ring for sealing, and is, hence, cumbersome to assemble and cannot be realized in a small size.

As for the moisture and humidity, Japanese Unexamined Patent Publication (Kokai) No. 10-153508 teaches the protection of the aluminum pads by using Ti/Pd where Pd is a precious metal without, however, any concrete description concerning the corrosive solution.

Further, International Patent Publication 2001-509890 teaches a method of preventing corrosion relying upon the protection of a filler material and proposes a method for leading out lead-wires for this purpose. The present inventors, however, have confirmed through experiment that silicon gel, which is a representative filler material, is not necessarily sufficient for protecting the aluminum pads and the like from the oxidizing water at the level of an exhaust gas aqueous solution.

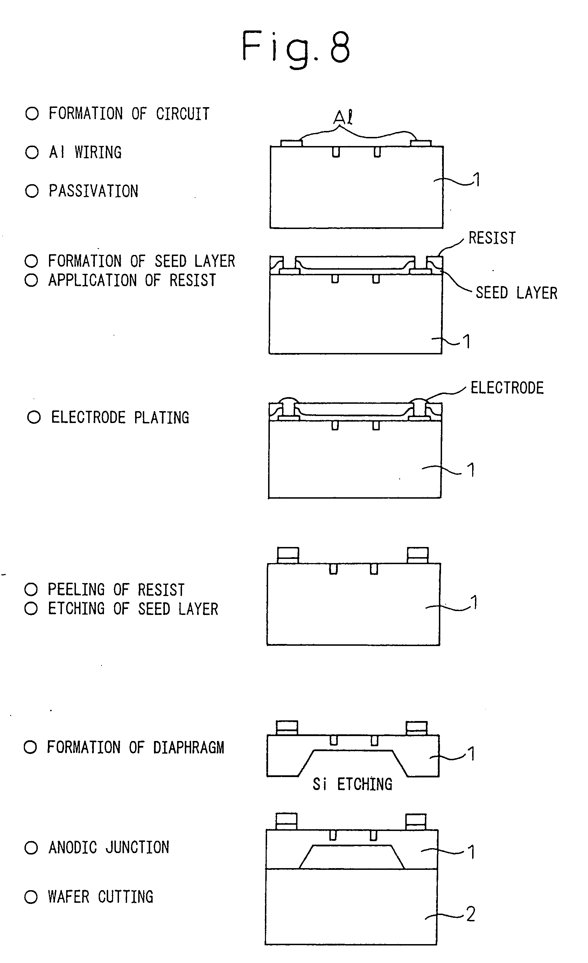

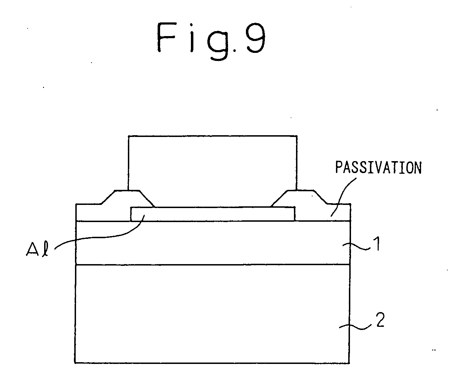

As for the production of the conventional semiconductor devices, the electrodes of the pressure sensor are formed by using aluminum wiring, and the wire (e.g., gold) is bonded in a state where the aluminum wiring is exposed. In this case, aluminum is often corroded depending upon an environment in which it is used due to the battery action of aluminum and gold. In order to prevent the corrosion of aluminum, it is contrived to form a metal film on the aluminum wiring. The forming method comprises, as illustrated, for example, in Fig. 8, forming a metal film on the whole surface of a semiconductor (silicon) wafer (silicon substrate) 1 by sputtering (vacuum evaporation), and removing unnecessary metal films by resist patterning, or forming a seed layer on the whole surface of the wafer, patterning the resist, and forming the electrodes by electric plating (2 is a glass substrate). However, these methods additionally require a step of applying the resist and a step of etching to drive up the cost. The electrode structure in this case becomes as illustrated in Fig. 9.

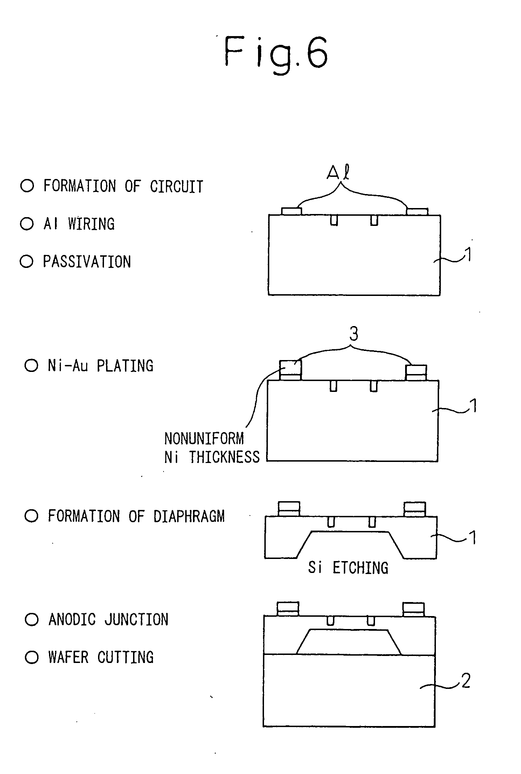

In the non-electrolytic nickel/gold plating, further, the metal film can only be formed on the aluminum wiring layer. Generally, however, there is employed a step of forming an electrode on the aluminum wiring by the non-electrolytic nickel/gold plating, forming a diaphragm and, then, joining the glass substrate. Fig. 6 illustrates a conventional flow of steps generally employed, and Fig. 5 illustrates an electrode structure. That is, referring to Fig. 6, the aluminum wiring is formed after the circuit is formed, and the surface of the circuit is protected by the passivation film. Here, the passivation is opened to the aluminum wiring. A nickel film is plated by the non-electrolytic nickel plating on the aluminum wiring that is opened and gold is formed on nickel by non-electrolytic gold plating that is effected continuously. A diaphragm is formed in a state where the nickel/gold film 3 is plated on the aluminum wiring, and a glass substrate 2 and a silicon wafer 1 are anodically joined. Thereafter, the wafer is cut into chips.

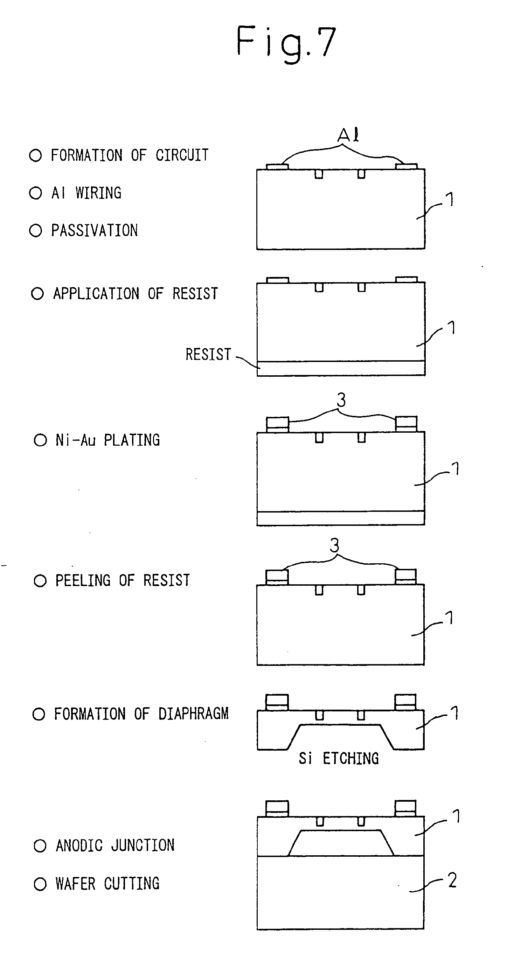

According to the conventional method, therefore, gold formed by the non-electrolytic nickel/gold plating could become a source of contamination in the subsequent steps. To prevent this, the diaphragm may be formed, the electrode may be formed and, then, the glass substrate may be joined causing, however, a problem in that silicon is exposed on the back surface of the wafer and the plated layer possesses an irregular thickness. In order for a metal to be homogeneously precipitated, a protection film (resist film or the like film) must be formed on the back surface of the wafer as illustrated in Fig. 7, and the steps become complex.

### Disclosure of the Invention

It is an object of the present invention to provide a semiconductor type sensor featuring improved corrosion resistance against the corrosive medium by solving the above-mentioned problems. Namely, the object is to markedly improve the corrosion resistance in the pad/wire peripheral portions through where signals of the semiconductor type sensor are transmitted. The gist of the invention resides in a semiconductor type sensor having, on a semiconductor substrate, a structural portion for detecting the physical quantity or the chemical component of a corrosive medium and an electric quantity conversion element, and having pads which are the output terminals for sending the detected electric signals to an external unit, wherein the pads are protected with a precious metal. The gist of the invention further resides in a method of producing a semiconductor type sensor comprising the steps of:
non-electrolytically plating a nickel film on the pads;
non-electrolytically plating a precious metal film on the nickel-plated film;
bonding precious metal wires; and
covering the pads and the wire-bonded portions with an insulating film.

The invention further has an object of providing a method of plating a semiconductor device best suited for the production of the semiconductor type sensor. That is, gold which is a precious metal having corrosion resistance is formed as a protection film on the conventional aluminum electrode, and an insulating film such as a gel protection film is formed thereon to decrease the probability of contact between the corrosive medium and aluminum, which forms a corrosive structure, in order to enhance the corrosion resistance of pads. The invention provides a method of plating a semiconductor device while maintaining a uniform thickness of the plated film, preventing the metal from being precipitated on the back surface of the semiconductor, preventing contamination in the subsequent steps and lowering the cost. That is, the present invention is a method of plating a semiconductor device wherein in directly forming connection terminals on the aluminum electrodes on a semiconductor substrate, the non-electrolytic plating is effected in a state where the back surface of the substrate is covered with an insulator.

### Brief Description of the Drawings

Fig. 1 is a view illustrating an embodiment of an electrode structure in a semiconductor type sensor according to the invention;

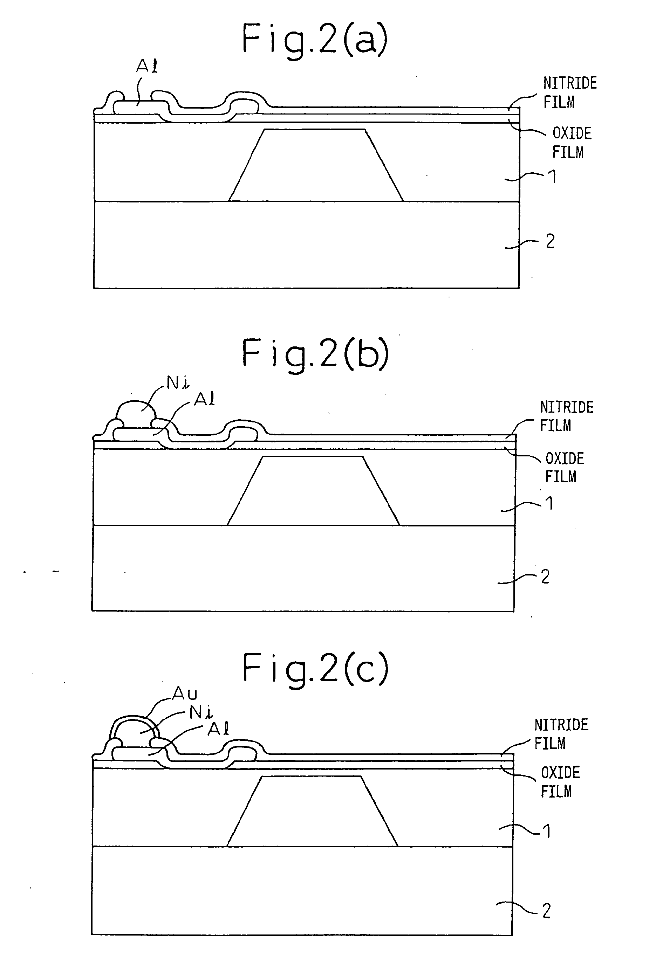

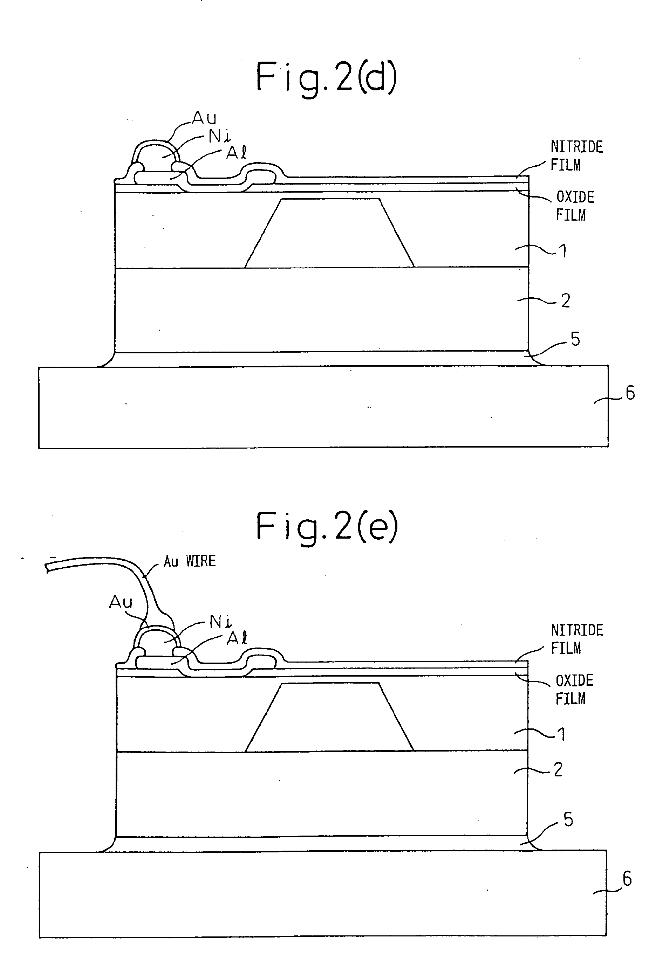

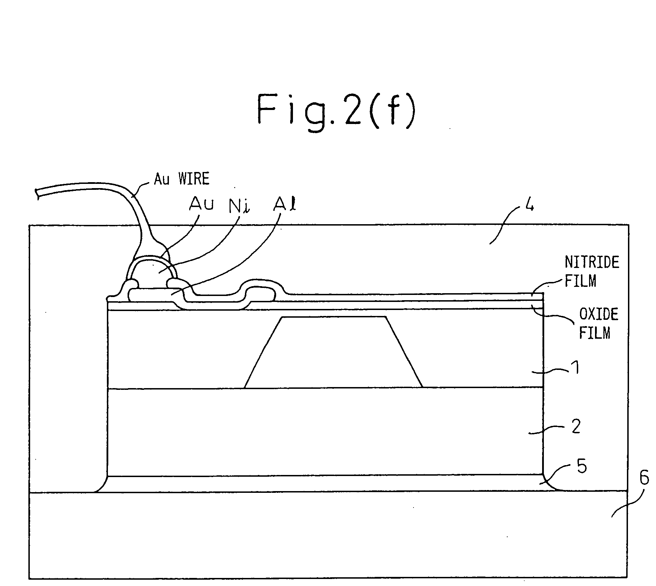

Figs. 2(a) to 2(f) are views schematically illustrating a flow of plating steps and the steps of assembling for producing the semiconductor type sensor of the present invention;
Fig. 3 is a view illustrating a flow of steps of a preferred method of plating the semiconductor device according to the invention;
Fig. 4 is a view illustrating an electrode structure in a conventional semiconductor type sensor;
Figs. 5 and 9 illustrate conventional general electrode structures; and
Figs. 6 to 8 illustrate a conventional flow of steps that are generally employed.

### Best Mode for Carrying Out the Invention

A semiconductor type sensor according to the invention has, in a semiconductor substrate such as wafer, a structural portion for detecting the physical quantity or the chemical component of a corrosive medium and an electric quantity conversion element, and has pads which are the output terminals for sending the detected electric signals to an external unit, wherein the pads are protected with a precious metal. The material forming pads is, preferably, aluminum. Usually, a glass substrate is arranged on the back surface of the semiconductor substrate. The precious metal used for protecting the pads in the present invention may be a single film of Au, Pt or Pd, or a composite film thereof. The precious metal is desirably obtained by non-electrolytically plating Ni/Au, Cu/Au, Ni/Pt or Ni/Pd and, particularly preferably, Ni/Au, successively, using a liquid not containing cyanide ions. The non-electrolytic plating is effected relying on the plating method of the invention that will be described later. There is no particular limitation to the thickness of the plated film. Wires are bonded to the pads for sending the detected electric signals to an external unit. Gold is best suited as a wire material. In this invention, the thus formed pads and wire-bonded portions are covered with an insulating film. The insulating film, material thereof and film thickness thereof may be those that have been widely used. For instance, there can be exemplified gel, primer + gel, or parylene + gel. As the gel, there can be exemplified fluorine gel, silicon gel or fluorosilicon gel.

The electrode structure of the semiconductor type sensor of the present invention is produced by a method comprising the steps of:
non-electrolytically plating a nickel film on the pads;
non-electrolytically plating a precious metal film on the nickel-plated film;
bonding precious metal wires; and
covering the pads and the wire-bonded portions with an insulating film.

A semiconductor type sensor according to the invention has, in a silicon semiconductor substrate, a structural portion for detecting the physical quantity and an electric quantity conversion element, and has pads, wherein the obtained electric signals are transmitted through wires. On the pads are formed nickel and gold films by the non-electrolytic plating, and the whole structure thereof is covered with a gel or other insulating film.

In the present invention, a pressure sensor can be exemplified as a semiconductor type sensor for detecting the physical quantity of the corrosive medium. Particularly desirably, it is the pressure sensor for measuring the pressure of the exhaust gas in an exhaust gas environment of an automotive engine. Further, it is the pressure sensor for measuring the pressure of a medium which is highly corrosive and is highly humid. These pressure sensors have a thin diaphragm region formed in the semiconductor substrate in a customary manner, exhibit a piezo-resistance effect due to the diffusion layer formed in this region, and are so constituted that the distortion is converted into a change in the resistance to detect the pressure.

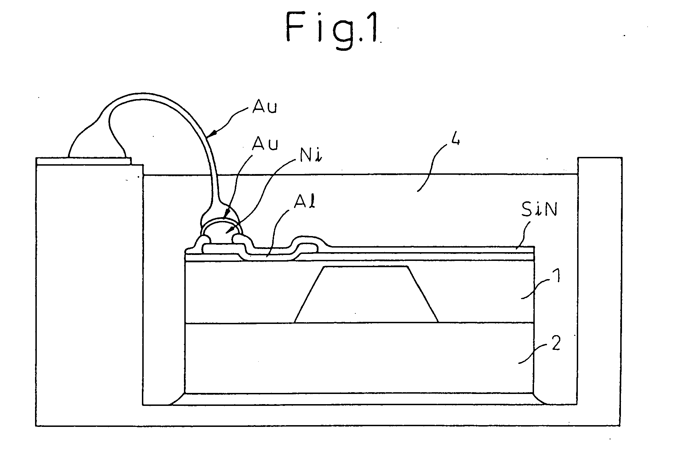

Concretely speaking, in the embodiment of the pressure sensor as shown in Fig. 1, the pads have a nickel layer formed by non-electrolytic plating maintaining a thickness of several microns on the aluminum layer of a thickness of 1.1 µm to assist the precipitation of gold. Then, gold of a thickness of about 0.2 µm is formed thereon non-electrolytically. Next, a gold wire is bonded (WB). This precludes most of the portions to where the corrosive solution comes in contact. However, a gap exists between the nickel film and the SiN film (chip protection film), and this portion is covered with an insulating film (gel/parylene/primer + gel).

This production method has an advantage in that the plating portion is a completely self-forming process requiring neither a semiconductor step such as exposure to light/etching nor an aligner/clean room/coater developer which is an expensive facility. The working can be effected by treatment after the semiconductor step.

As described above, the present invention prevents the corrosion of the signal transmission portions in the sensor that detects the physical quantities and chemical components of the corrosive medium, and contributes to extending the life of the product as compared to the conventional counterparts. Concretely speaking, when immersed in a strongly acidic aqueous solution of 90°C having a pH of about 1.7, the device offers a life which is about twice as long as that of the device of a structure in which aluminum is exposed.

Next, described below is a method of plating the semiconductor device of the present invention.

In the method of the present invention, in directly forming connection terminals on the aluminum electrodes on a semiconductor substrate (wafer), the non-electrolytic plating is effected in a state where the back surface of the substrate is covered with an insulator. It is desired that the insulator is a glass substrate which is a part constituting the product. In this case, the glass substrate also serves as a material for covering the back surface of the substrate.

It is desired that the non-electrolytic plating treatment of the present invention is a non-electrolytic nickel plating. In a further preferred embodiment, nickel is formed by the non-electrolytic nickel plating and, then, gold is formed by the non-electrolytic gold plating. These non-electrolytic nickel plating and non-electrolytic gold plating themselves can be carried out in a customary manner. According to the present invention, however, they are carried out after the glass substrate is joined as described above.

In the method of the present invention, the aluminum electrode is usually selected from any one of pure Al wiring, Al-Si wiring, Al-Cu wiring or Al-Si-Cu wiring. The pure Al wiring is usually the wiring of highly pure aluminum of a purity of not lower than 99.99% or not lower than 99.999%. When silicon is contained, the amount of silicon is, usually, about 1%. The non-electrolytic nickel plating solution is, for example, a plating solution based on, for example, sodium hypophosphite or a boron compound.

In the non-electrolytic nickel/gold plating, zinc is substituted for the aluminum wiring by the zincate treatment, and nickel is precipitated by the non-electrolytic nickel plating. It is desired that the nickel plating solution contains hypophosphorous acid ions as a reducing agent. On the nickel plating, gold is desirably formed by the non-electrolytic plating to prevent the oxidation of nickel and to improve the junction to the wire that is bonded.

In the preferred embodiment of the invention, further, the glass substrate may be covered with an insulator so that pores in the glass substrate will not be soaked with the non-electrolytic plating solution. The glass substrate can be covered with the insulator via an adhesive or a wax. The material that covers via the adhesive is desirably a resin or a glass. In covering the glass substrate with an insulator, the adhesive or the wax may be applied to the outer circumference only of the glass so that the pores in the glass are little penetrated with the adhesive or the wax. As described above, the plating method of the present invention is best suited for the production of the semiconductor type sensors.

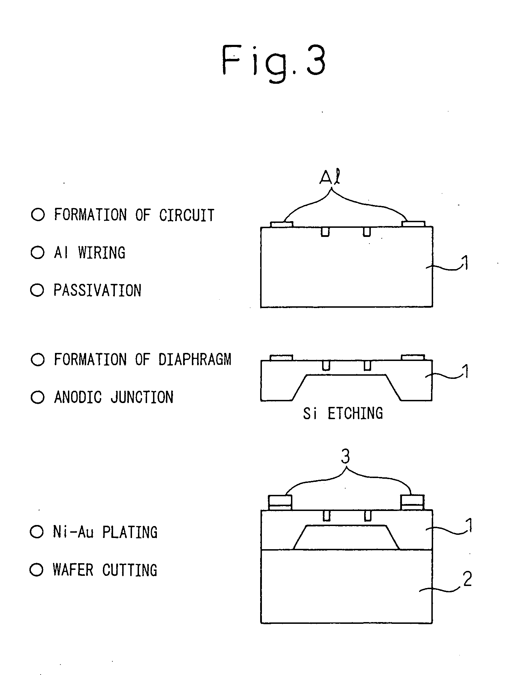

Next, a preferred embodiment of the plating method of the invention will be described with reference to the drawings. Fig. 3 illustrates a flow of steps of the invention. In Fig. 3, an aluminum wiring is formed after a circuit is formed and, then, a passivation film is formed to protect the surface of the circuit. Then, a diaphragm is formed to anodically join the glass substrate 2 and the silicon wafer 1 together. A nickel film is plated on the aluminum wiring by the non-electrolytic nickel plating and, then, gold is continuously formed on nickel by the non-electrolytic gold plating. In a state where the nickel/gold film 3 is plated on the aluminum wiring, the wafer is cut into chips. The electrode structure that is finally obtained becomes the same as that of the prior art illustrated in Fig. 5.

In the method of the present invention as described above, the diaphragm is formed, the glass substrate is joined and, then, the electrode is formed (the electrode is formed or the non-electrolytic nickel/gold plating is effected in the final step) preventing the gold contamination in the subsequent steps. Preferably, the glass substrate plays the role of the covering material to cover the back surface of the semiconductor substrate preventing the precipitation of metal on the back surface of the semiconductor substrate and enabling the plating to be uniformly accomplished.

### Industrial Applicability

The present invention invention provides a semiconductor type sensor featuring improved corrosion resistance against a corrosive medium.

## Claims

1. A semiconductor type sensor having, in a semiconductor substrate, a structural portion for detecting the physical quantity or the chemical component of a corrosive medium and an electric quantity conversion element, and having pads which are the output terminals for sending the detected electric signals to an external unit, wherein the pads are protected with a precious metal.

2. A semiconductor type sensor according to claim 1, wherein the material forming pads is aluminum.

3. A semiconductor type sensor according to claim 1 or 2, wherein a glass is arranged on the back surface of the semiconductor substrate.

4. A semiconductor type sensor according to any one of claims 1 to 3, wherein the precious metal is a single film of Au, Pt or Pd or a composite film thereof.

5. A semiconductor type sensor according to any one of claims 1 to 4, wherein the precious metal is formed by the non-electrolytic plating of Ni/Au, Cu/Au, Ni/Pt or Ni/Pd by using a solution not containing cyanide ions.

6. A semiconductor type sensor according to any one of claims 1 to 5, wherein gold is used as the wire material bonded to the pads for sending the detected electric signals to an external unit.

7. A semiconductor type sensor according to claim 6, wherein the pads and the wire-bonded portions are covered with an insulating film.

8. A semiconductor type sensor according to claim 7, wherein the insulating film is formed by using a gel, a parylene + gel, or a primer + gel.

9. A semiconductor type sensor according to claim 8, wherein the gel is a fluorine gel, a silicon gel or a fluorosilicon gel.

10. A semiconductor type sensor according to any one of claims 1 to 9, wherein the semiconductor type sensor for detecting the physical quantity of a corrosive medium is a pressure sensor.

11. A semiconductor type sensor according to any one of claims 6 to 10, wherein the semiconductor type sensor is a pressure sensor for measuring the pressure of the exhaust gas in an exhaust gas environment of an automotive engine.

12. A semiconductor type sensor according to any one of claims 6 to 10, wherein the semiconductor type sensor is a pressure sensor for measuring the pressure of a medium which is corrosive and is highly humid.

13. A semiconductor type sensor according to any one of claims 6 to 12, wherein the semiconductor type sensor has a diaphragm and a piezo-resistance effect.

14. A method of producing a semiconductor type sensor comprising the steps of:
non-electrolytically plating a nickel film on the pads;
non-electrolytically plating a precious metal film on the nickel-plated film;
bonding precious metal wires; and
covering the pads and the wire-bonded portions with an insulating film.

15. A method of plating a semiconductor device wherein in directly forming connection terminals on the aluminum electrodes on a semiconductor substrate, the non-electrolytic plating is effected in a state where the back surface of the substrate is covered with an insulator.

16. A method of plating a semiconductor device according to claim 15, wherein the insulator is a glass substrate which is a part constituting the product.

17. A method of plating a semiconductor device according to claim 16, wherein the non-electrolytic plating treatment is a non-electrolytic nickel plating.

18. A method of plating a semiconductor device according to claim 15, wherein nickel is formed by the non-electrolytic nickel plating and, then, gold is formed by the non-electrolytic gold plating.

19. A method of plating a semiconductor device according to claim 18, wherein the non-electrolytic nickel plating and the non-electrolytic gold plating are effected after the glass substrate is joined.

20. A method of plating a semiconductor device according to claim 15, wherein the aluminum electrodes are formed by any one of pure Al wiring, Al-Si wiring, Al-Cu wiring or Al-Si-Cu wiring.

21. A method of plating a semiconductor device according to any one of claims 17 to 19, wherein the non-electrolytic nickel plating solution is a plating solution based on a sodium hypophosphite or a boron compound.

22. A method of plating a semiconductor device according to claim 19, wherein the glass substrate is covered with an insulator so that the pores in the glass substrate are not soaked with the non-electrolytic plating solution.

23. A method of plating a semiconductor device according to claim 22, wherein the glass substrate is covered with an insulator via an adhesive or a wax.

24. A method of plating a semiconductor device according to claim 23, wherein the material that covers via the adhesive is a resin or a glass.

25. A method of plating a semiconductor device according to claim 23, wherein the glass substrate is covered with an insulator via an adhesive or a wax which is applied to the outer circumferential portion only of the glass so that the pores in the glass are little penetrated with the adhesive or the wax.

26. A method of plating a semiconductor device according to claim 25, wherein the material that covers via the adhesive is a resin or a glass.

27. A semiconductor type sensor produced by using the method of plating according to any one of claims 15 to 26.
